# EUROPEAN PATENT APPLICATION

(11) **EP 1 453 203 A1**
(43) Date of publication of application: **01.09.2004**
(21) Application number: 04100504.2
(22) Date of filing: 11.02.2004
(51) Int. Cl.: H03K 5/135

(54) **Miller effect compensation for a DLL phase interpolator**

(30) Priority: 28.02.2003 US 377427
(71) Applicant: Sun Microsystems, Inc., Santa Clara, California 95054 (US)
(72) Inventor: Gauthier, Claude R., Cupertino, CA 95014 (US); Amick, Brian W., Austin, TX 78759 (US); Lui, Dean, Sunnyvale, CA 94086 (US)
(74) Representative: Weihs, Bruno

(57) **Abstract**

A delay locked loop design uses a fixed capacitance to load down a signal output from a phase selector of the delay locked loop to a phase interpolator of the delay locked loop. Such loading counteracts for variable capacitive coupling that occurs in the phase interpolator as interpolation weights to the phase interpolator change. Without such loading of the output of the phase selector, the delay of the phase selector varies as a function of the capacitance coupling of the phase interpolator.

## Description

### Background of Invention

As the frequencies of modem computers continue to increase, the need to rapidly transmit data between chip interfaces also increases. To accurately receive data, a clock is often sent to help recover the data. The clock determines when the data should be sampled by a receiver's circuits.

The clock may transition at the beginning of the time the data is valid. The receiver would prefer, however, to have a signal during the middle of the time the data is valid. Also, the transmission of the clock may degrade as it travels from its transmission point. In both circumstances, a delay locked loop, or DLL, can regenerate a copy of the clock signal at a fixed phase shift from the original.

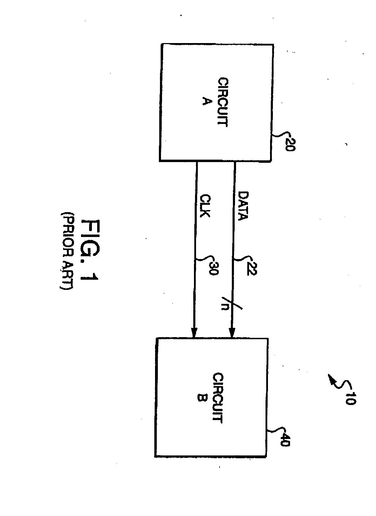

Figure 1 shows a section of a typical computer system component **10.** Data **22** that is 'n' bits wide is transmitted from circuit A **20** to circuit B **40**. To aid in the recovery of the transmitted data, a clock composed of a clock signal **30**, or CLK, is also transmitted with the data. The circuits could also have a path to transmit data from circuit B **40** to circuit A **20** along with an additional clock (not shown).

The clock signal **30** may transition from one state to another at the beginning of the data transmission. Circuit B **40** requires a signal temporally located some time after the beginning of the valid data. Furthermore, the clock signal **30** may have degraded during transmission. A DLL has the ability to regenerate the clock signal **30** to a valid state and to create a phase shifted version of the clock to be used by other circuits, for example, a receiver's sampling signal. The receiver's sampling signal determines when the input to the receiver should be sampled.

The DLL must delay an output signal versus an input signal by a known phase shift. The entire cycle of a signal is considered a 360 degree phase shift. By specifying a phase shift delay, the same relative delay is specified; however, the absolute amount of delay may be different. For example, a 100 MHz clock signal has a 10 ns cycle time. Therefore, a phase shift of 360 degrees would indicate that an entire cycle, or 10 ns, of delay has been added. A 30 degree phase shift is approximately 0.833 ns. A 200 MHz clock signal has a cycle time of 5 ns. A 30 degree phase shift is approximately 0.417 ns. The phase shifts in these examples are the same; however, the temporal delays are not.

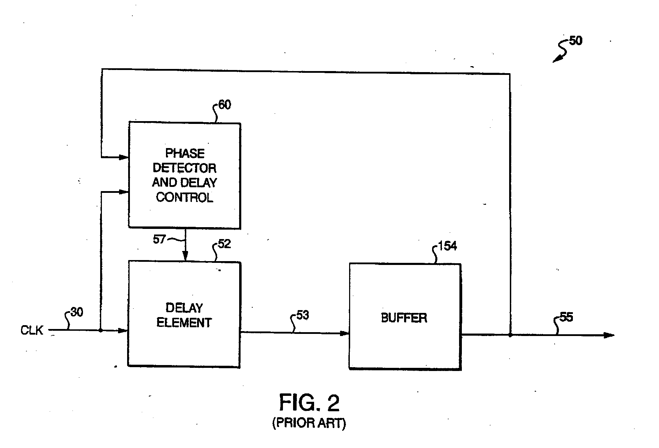

In Figure 2, a DLL **50** is composed of three basic components: a delay element **52**, a buffer circuit **54**, and a phase detector and delay control **60**. The delay element **52** generates a delayed signal **53** that is delayed relative an input signal **30**. For this example, the input signal **30** is CLK. The phase detector and delay control **60**, or phase adjustment device, controls the amount of delay generated by the delay element **52** based on the phase difference between the input signal **30** and a buffered output signal **55**. The buffer circuit **54** takes the delayed signal **53** from the delay element **52** and buffers the delayed signal **53** to any circuits that must receive a buffered output signal **55**, such as a receiver's sampling signal. By buffering the output signal **53,** the characteristics of the delay element **52** are not changed due to the capacitive and/or resistive load on the delayed signal **53.**

### Summary of Invention

According to one or more embodiments of the present invention, an integrated circuit comprises a phase selector stage arranged to receive phase shifted signals and output at least a pair of the phase shifted signals, at least one signal wire arranged to propagate the at least a pair of the phase shifted signals, a phase interpolator stage having an input operatively connected to the at least one signal wire (where the phase interpolator stage is arranged to receive the at least a pair of the phase shifted signals and interpolate between the at least a pair of the phase shifted signals), and at least one capacitor operatively connected to the at least one signal wire.

According to one or more embodiments of the present invention, an integrated circuit comprises means for generating phase shifted signals dependent on an input clock signal, means for selecting at least a pair of the phase shifted signals, means for propagating the selected at least a pair of the phase shifted signals, means for interpolating between the selected at least a pair of the phase shifted signals, and means for loading the means for propagating such that the means for interpolating does not substantially load the means for selecting.

According to one or more embodiments of the present invention, a method for operating a delay locked loop comprises inputting a plurality of phase shifted differential signal pairs, selecting at least one of the phase shifted differential signal pairs, propagating the at least one selected phase shifted differential signal pair, interpolating between signals in the at least one selected phase shifted differential signal pair, and capacitively loading the propagating such that the interpolating does not substantially affect the selecting.

Other aspects and advantages of the invention will be apparent from the following description and the appended claims.

### Brief Description of Drawings

Figure 1 shows a typical computer system component.

Figure 2 shows a delay locked loop block diagram.

Figure 3 shows a block diagram of a typical delay locked loop.

Figure 4 shows a portion of a delay locked loop.

Figure 5 shows a behavioral graph relating to the portion of the delay locked loop shown in Figure 4.

Figure 6 shows a portion of a delay locked loop in accordance with an embodiment of the present invention.

Figure 7 shows a behavioral graph relating to the portion of the delay locked loop shown in Figure 6.

### Detailed Description

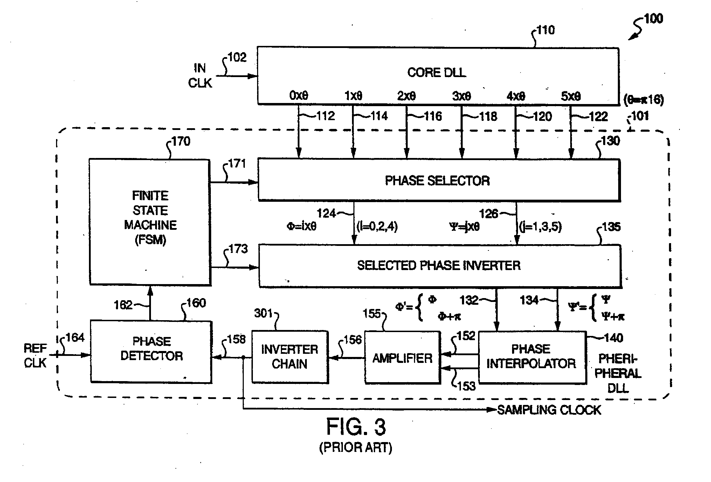

Figure 3 shows a block diagram **100** of a delay locked loop (DLL) architecture. This architecture is based on two cascaded loops: a conventional first-order analog core DLL **110** and a digital peripheral DLL **101**. The core DLL **110** is locked at a **180** degrees phase shift. Assuming that the delay line of the core DLL **110** comprises six buffers, their outputs are six clocks having phases evenly spaced by 30 degrees. The core DLL **110** has an input of IN CLK **102** that is used to create the six delayed outputs. The first output is a zero degree phased output **112** with each subsequent output adding an additional 30 degree phase shift at phased outputs **114, 116, 118, 120,** and **122,** respectively.

The peripheral DLL **101** selects a pair of clocks, φ **124** and ψ **126,** to interpolate between. The clocks, φ **124** and ψ **126,** are selected from the six phased outputs **112, 114, 116, 118, 120,** and **122** by a phase selector **130.** Clocks φ **124** and ψ **126** can potentially be inverted in order to cover the full 0 degree to 360 degree phase range by a selective phase inverter **135.** Clocks φ' **132** and ψ' **134** drive a digitally controlled phase interpolator **140** which generates a differential clock: main clock Θ **152** and its complement, main clock Θ_ **153.** The phase of the main clock Θ **152** (and its complement) can be any of the N quantized phase steps between the phases of clocks φ' **132** and ψ' **134,** where 0..N is the interpolation controlling word range. The main clock Θ **152** is approximately equal to φ' + (1 - α/16)×(ψ' - φ') where α = (0, 1,..., 16).

The main clock Θ **152** and main clock Θ_ **153** of the phase interpolator **140** drive an amplifier **155** that increases a voltage swing of the main clock Θ **152** and main clock Θ_ **153** to create a larger relative voltage swing at the amplifier output **156.** The amplifier output **156** characteristics may follow the main clock Θ **152** characteristics with the larger relative voltage swing. The inverter chain **301** buffers the amplifier output **156**. A buffer, for the purposes of this description, creates a copy of the input signal at the output that is better suited to drive a larger load (i.e., generates a rise or fall time of the output signal similar to the input signal even though the amount of resistance and/or capacitance attached to the output is greater). The inverter chain **301** buffers the amplifier output **156** and generates an inverter chain output **158** to drive a sampling clock (i.e., latching signal) of one or more receivers.

The inverter chain output **158** also drives a phase detector **160** that compares the inverter chain output **158** to a reference clock, REF CLK, **164**. A phase detector output **162** is used by a finite state machine (FSM) **170** to control the phase selector **130** and the selective phase inverter **135**, through FSM control lines **171** and **173**, respectively. The finite state machine (FSM) **170** also controls the phase interpolator **140** mixing weight (not shown).

The FSM **170** adjusts the phase of the main clock Θ **152** and main clock Θ_ **153** according to the phase detector output **162.** Generally, this means just changing the phase interpolator **140** mixing weight by one. If, however, the phase interpolator **140** controlling word has reached its minimum or maximum limit, the **FSM 170** must change the phase of φ **124** or ψ **126** to the next appropriate selection. This phase selection change might also involve an inversion of the corresponding clock if the current interpolation interval is adjacent to the 0 degree or 180 degree boundary. As these phase selection changes happen only when the corresponding phase mixing weight is zero, no glitches occur on the output clock. The digital "bang-bang" nature of the control results in dithering around the zero phase error point in the lock condition. The dither amplitude is determined by the phase interpolator **140** and the delay through the peripheral DLL **101.**

In this architecture, the main clock Θ **152** and main clock Θ_ **153** phase can be rotated, so no hard limits exist in the loop phase capture range: the loop provides unlimited (modulo 2π) phase shift capability. This property eliminates boundary conditions and phase relationship constraints. The only requirement is that the IN CLK **102** and REF CLK **164** are plesiochronous (i.e., their frequency difference is bounded), making this architecture suitable for clock recovery applications.

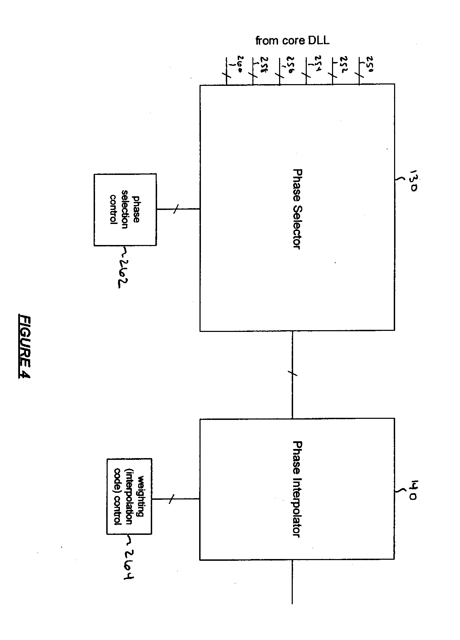

Figure 4 shows a logic level diagram of a portion of the delay locked loop **101** shown in Figure 3 involving the phase selector stage **130** and the phase interpolator stage **140**. The phase selector stage **130** inputs six pairs of phase shifted differential signals **250, 252, 254, 256, 258,** and **260** from the DLL core (**110** in Figure 3). Depending on some phase selection control logic **262**, one of the six pairs of phase shifted differential signals **250, 252, 254, 256, 258**, and **260** is selected and outputted to the phase interpolator stage **140**, which, in turn, interpolates between the selected phase shifted differential signal pair dependent on weighting, or interpolation code, control logic **264.**

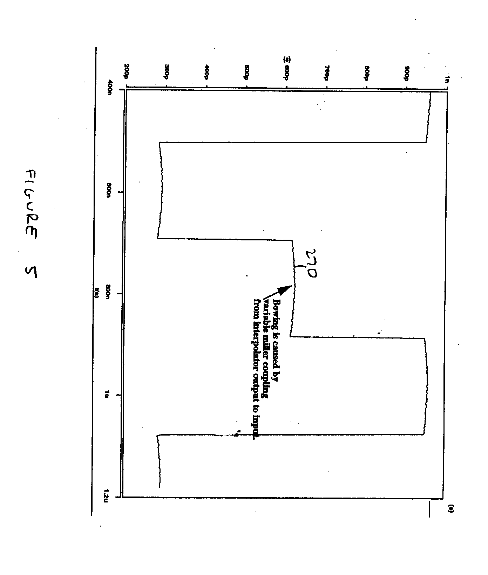

To demonstrate one behavioral aspect of the portion of the delay locked loop shown in Figure 4, Figure 5 shows a graph of the delay of the phase selector stage **130** as the interpolation codes, i.e., weights, to the phase interpolator stage **140** change. As can be seen in Figure 5, there is a "bowing" **270** in this delay of the phase selector stage **130**. Those skilled in the art will understand that this "bowing" effect peaks when the interpolation weight to the phase interpolator stage **140** is 50%. This results from the fact that the input capacitance to the phase interpolator stage **140** is actually variable dependent on the interpolation codes, i.e., weights applied to the phase interpolator stage **140**. Thus, the phase interpolator stage **140** can be viewed as substantially loading the phase selector stage **130**. In other words, the capacitive coupling from the input of the phase interpolator stage **140** to the output of the phase interpolator stage **140** varies as the output waveform from the phase interpolator stage **140** changes. Such an effect is known as a "Miller" effect. Accordingly, such indeterministic capacitive coupling in the phase interpolator stage **140** causes variance in the delay of the phase selector stage **130.**

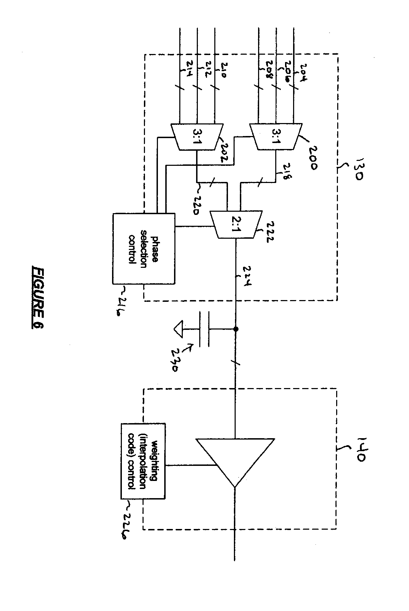

In order to counteract such a Miller effect, embodiments of the present invention relate to a delay locked loop design that compensates for the variable capacitive coupling in a phase interpolator stage of the delay locked loop. Figure 6 shows a portion of a delay locked loop in accordance with an embodiment of the present invention. In part, Figure 6 shows the phase selector stage **130** and the phase interpolator stage **140**. The phase selector stage **130** includes two 3:1 multiplexors **200** and **202** that each select one of three phase shifted differential signal pairs **204, 206, 208, 210, 212**, and **214** depending on phase selection control logic **216**. The outputs **218** and **220** from the two 3:1 multiplexors **200** and **202** serve as inputs to a 2:1 multiplexor **222**, which, in turn, outputs a selected phase shifted differential signal pair **224** dependent on the phase selection control logic **216**. The selected differential signal pair **224** is transmitted to the phase interpolator stage **140** for interpolation, where the interpolation is dependent on weighting, or interpolation code, control logic **226**.

In order to compensate for the variable capacitive loading on the phase selector stage **130** by the phase interpolator stage **140** that occurs as the interpolation codes to the phase interpolator **140** change, a fixed capacitance is operatively connected to the signal wire **224** connecting the phase selector stage **130** and the phase interpolator stage **140**. Such a fixed capacitance may be chosen so as to dominate the variability of capacitive coupling in the phase interpolator stage **140**. In effect, the signal wire **224** is "loaded down" by the fixed capacitance **230** so as to not be substantially affected by the changing capacitive coupling in the phase interpolator stage 140. Those skilled in the art will understand that the fixed capacitance **230** shown in Figure 6 may be implemented by a variety of means, e.g., metal capacitors, off-chip capacitors, gate capacitors, etc.

Those skilled in the art will further understand that, in one or more embodiments, the multiplexors in a phase selector stage of a delay locked loop may be sized to effectuate desired edge rates on signals generated from the phase selector stage. Moreover, those skilled in the art will understand that, in one or more embodiments, the phase selector stage may be designed so as to contain any number of multiplexors.

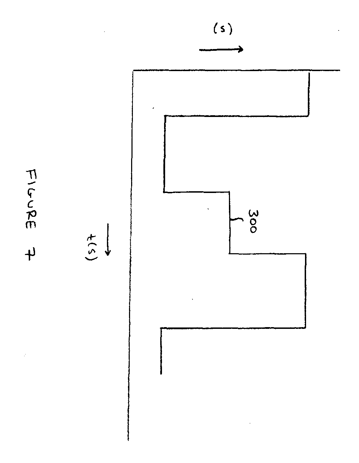

To demonstrate one behavioral aspect of the portion of the delay locked loop shown in Figure 6, Figure 7 shows a graph of the delay of the phase selector stage **130** as the interpolation codes, i.e., weights, to the phase interpolator stage **140** change. As can be seen in Figure 7 with reference to Figure 5, a "bowing" **300** in Figure 7 is flattened with respect to the "bowing" (270 in Figure 5) shown in Figure 5. This flattening results from the loading down, by means of the fixed capacitance **230**, of the signal wire (**224** in Figure 6) operatively connecting the phase selector stage (**130** in Figure 6) and the phase interpolator stage (**140** in Figure 6).

Advantages of the present invention may include one or more of the following. In one or more embodiments, because a delay locked loop is designed to compensate for variable capacitive coupling present in a phase interpolator of the delay locked loop, a delay through a phase selector of the delay locked loop may remain constant.

While the invention has been described with respect to a limited number of embodiments, those skilled in the art, having benefit of this disclosure, will appreciate that other embodiments can be devised which do not depart from the scope of the invention as disclosed herein. Accordingly, the scope of the invention should be limited only by the attached claims.

## Claims

1. An integrated circuit, comprising:
a phase selector stage arranged to receive phase shifted signals and output at least a pair of the phase shifted signals;
at least one signal wire arranged to propagate the at least a pair of the phase shifted signals;
a phase interpolator stage having an input operatively connected to the at least one signal wire, wherein the phase interpolator stage is arranged to receive the at least a pair of the phase shifted signals and interpolate between the at least a pair of the phase shifted signals; and
at least one capacitor operatively connected to the at least one signal wire.

2. The integrated circuit of claim 1, wherein the at least one capacitor has a capacitance that loads down the at least one signal wire such that the phase interpolator stage cannot substantially load the phase selector stage.

3. The integrated circuit of claim 1, further comprising a finite state machine, wherein the phase selector stage is dependent on the finite state machine, and wherein the finite state machine is dependent on the phase interpolator stage.

4. The integrated circuit of claim 1, further comprising a phase selection control logic, wherein the phase selector stage is dependent on the phase selection control logic.

5. The integrated circuit of claim 4, the phase selector stage comprising:
at least one multiplexor arranged to input at least one of the phase shifted signals and output a selected phase shifted signal dependent on the phase selection control logic.

6. The integrated circuit of claim 1, further comprising interpolation code control logic, wherein the phase interpolator stage is dependent on the interpolation code control logic.

7. The integrated circuit of claim 1, further comprising a delay locked loop that comprises the phase selector stage and the phase interpolator stage.

8. The integrated circuit of claim 1, wherein a coupling capacitance of the phase interpolator stage varies as interpolation codes to the phase interpolator stage vary.

9. The integrated circuit of claim 1, wherein the phase selector stage is arranged to receive phase shifted signal from a core delay locked loop.

10. The integrated circuit of claim 9, wherein the phase shifter signals are generated dependent on an input clock signal to the core delay locked loop.

11. The integrated circuit of claim 1, wherein the at least one capacitor is a metal capacitor.

12. The integrated circuit of claim 1, wherein the at least one capacitor is one of a gate capacitor and an off-chip capacitor.

13. An integrated circuit, comprising:
means for generating phase shifted signals dependent on an input clock signal;
means for selecting at least a pair of the phase shifted signals;
means for propagating the selected at least a pair of the phase shifted signals;
means for interpolating between the selected at least a pair of the phase shifted signals; and
means for loading the means for propagating such that the means for interpolating does not substantially load the means for selecting.

14. The integrated circuit of claim 13, further comprising a means for controlling the means for selecting.

15. The integrated circuit of claim 14, wherein the means for controlling is dependent on the means for interpolating.

16. The integrated circuit of claim 14, wherein the means for selecting comprises means for inputting the phase shifted signals and means for outputting the at least a pair of the phase shifted signals dependent on the means for controlling.

17. A method for operating a delay locked loop, comprising:
inputting a plurality of phase shifted differential signal pairs;
selecting at least one of the phase shifted differential signal pairs;
propagating the at least one selected phase shifted differential signal pair;
interpolating between signals in the at least one selected phase shifted differential signal pair; and
capacitively loading the propagating such that the interpolating does not substantially affect the selecting.

18. The method of claim 17, further comprising generating the plurality of phase shifted differential signal pairs dependent on a clock signal.

19. The method of claim 17, further comprising controlling the selecting, wherein the controlling is dependent on the interpolating.

20. The method of claim 17, generating a sampling clock signal dependent on the interpolating.
